# EUROPEAN PATENT APPLICATION

(11) **EP 4 786 760 A1**
(43) Date of publication of application: **05.08.2026**
(21) Application number: 25155491.1
(22) Date of filing: 03.02.2025
(51) Int. Cl.: F01M 13/00, F01M 13/04

(54) **PRESSURE EQUALIZATION DEVICE FOR ATTACHMENT TO A HOUSING, IN PARTICULAR AN ENGINE BLOCK**

(71) Applicant: Newfrey LLC, New Britain, CT 06053 (US)
(72) Inventor: Stau, Bastian, 35394 Gießen (DE); Boerger, Kai, 35394 Gießen (DE)
(74) Representative: Haarpatent Patentanwälte Krämer Meyer

(57) **Abstract**

A pressure equalization device (1) for attachment to an opening of a housing is provided, comprising a base body (2) that includes an inlet (3) and an outlet (4), wherein the inlet (3) is designed to be fluidically connected to an interior of the housing and the outlet (4) is designed to be fluidically connected to an environment of the housing. The inlet and outlet (3, 4) are fluidically connected via a plurality of fluid channels (10, 12) extending in the base body (2). In addition, the pressure equalization device (1) comprises a gas-permeable and oil-repellent filter element (13) provided in the outlet (4), wherein a cap (17) is attached to the inlet (3), which cap (17) comprises at least one aperture (21) for the flow of a fluid.

## Description

The invention refers to a pressure equalization device that can be attached to a housing and that is designed to allow a fluid to flow from the housing through fluid channels arranged in the pressure equalization device into an environment. The pressure equalization device is for instance a motor vent plug.

It may be necessary to vent a housing, e.g. a motor housing, if there are pressure differences between an interior space of the housing and an environment surrounding the housing. Otherwise, the housing may be damaged.

US 11,940,056 B2 describes a vehicle driveline component that includes a tubular body, a relief valve, a vent cover and a pin. The tubular body has a first and second axial ends and defines an interior circumferential surface. The relief valve is mounted in the tubular body between the first and second axial ends. The vent cover is mounted to the tubular body and covers the second axial end. The pin is mounted to the tubular body at a location between the first axial end and the relief valve. The pin extends through the interior circumferential surface into a hollow interior of the tubular body.

DE 10 2018 111 850 A1 discloses a ventilation device for ventilating and/or venting a machine housing, comprising a housing with a ventilation duct that comprises at least one vent opening and at least one ventilation opening to an environment. The vent opening can be sealed by means of a vent valve that opens under excess pressure in the interior of the ventilation duct towards the environment. In addition, the ventilation opening can be sealed by means of a ventilation valve that opens under negative pressure in the interior.

A device is known from DE 195 23 454 B4 in which the ventilation and venting of a machine housing is carried out with separate channels for ventilation and venting, wherein the air sucked in is supplied via a ventilation opening in the and passes through a gas-permeable cover element that is impermeable to liquids and, via a prestressed valve element that opens in the direction of the interior of the gearbox or housing when subjected to negative pressure, into the ventilation duct. During venting, the exhaust air is conducted from the vent duct through a likewise prestressed valve element, which opens outwards under excess pressure, to a vent opening in the housing wall. The ventilation and exhaust ducts and the ventilation and exhaust openings are spatially separated from each other in such a way that exhaust air contaminated with oil particles that escapes from the inside of the gearbox or housing cannot enter the ventilation duct via the ventilation opening.

WO 2015/017377 A1 discloses a venting system for housings that contain synthetic or non-synthetic oil-based products such as lubricants. The system uses a flow control module that improves the service life and performance of the venting system. This system is particularly relevant for automotive applications such as transmission housings and brake housings, where pressure equalization is critical. The venting system features an expanded polytetrafluoroethylene (ePTFE) gas-permeable, liquid-impermeable membrane that allows air to pass through but blocks liquids and contaminants. It also contains a fibrous sorbent to absorb lubricant aerosols.

US 2023/0296039 A1 describes an oil separator with a labyrinth structure within a breather. This arrangement allows the separation of aerosols or foam from liquids as they pass through, reducing their presence in the discharged air. This eliminates the need for a membrane or filter element. The oil separator housing has a media inlet for gaseous media and directs them through the labyrinth structure, which is designed to redirect flow paths and improve separation efficiency.

The problem with the known devices is that a filter element is necessary for efficient pressure equalization and, above all, to prevent liquid from leaking out, for example. However, such filter elements tend to become clogged by viscous liquids. This affects the functioning of the filter element and can even lead to the device no longer functioning.

The object of the invention is to provide a pressure equalization device that allows the use of a filter element.

The above-mentioned object is achieved by the invention defined in independent claim 1. Preferred embodiments are described in the dependent claims.

A pressure equalization device for attachment to an opening of a housing is provided, comprising a base body that includes an inlet and an outlet, wherein the inlet is designed to be fluidically connected to an interior of the housing and the outlet is designed to be fluidically connected to an environment of the housing, wherein said inlet and outlet are fluidically connected via a plurality of fluid channels extending in the base body, and with a gas-permeable and oil-repellent filter element provided in the outlet, wherein a cap is attached to the inlet, which cap comprises at least one aperture for the flow of a fluid. The invention describes a pressure equalization device for a housing, preferably an engine housing, particularly preferably an electric motor housing. The pressure equalization device can be easily attached and detached to the housing. Pressure fluctuations can occur, especially when the housing is being transported, and these must be equalized to prevent damage to the housing. A filter element with oil-repellent properties is used to prevent liquid, especially oil, from leaking out of the housing into the surrounding area during pressure equalization. It has surprisingly been found that the favorable embodiment of the pressure equalization device can prevent the filter element from becoming clogged. The use of the cap and the fluid channels not only reduces the flow rate of the fluid flowing through, but also cools the fluid, causing liquid, especially oil, to condense. The condensed liquid can then flow back into the housing.

For the purposes of the invention, a fluid is defined as matter in the liquid and gaseous state of aggregation, as well as suspensions and aerosols. An example of this is oil mist, which, in addition to gas, also contains liquid oil droplets. For the purposes of the invention, a housing is defined as a basically closed system, such as an engine housing.

For the purpose of the invention, the pressure equalization device can be referred to as vent plug.

The base body can be designed in a tubular embodiment. The base body advantageously encloses a cavity. The base body advantageously comprises a first axial end and a second axial end, wherein the said inlet is present at the first axial end and the said outlet is present at the opposite second axial end of the base body. The base body can be attached to an opening in the housing with its first axial end, i.e. the inlet first.

Several fluid channels are provided in the base body. In one embodiment, the base body can enclose a cavity that is subdivided by a plurality of radially running segments extending axially to the longitudinal axis of the base body. The segments may be rectangular or plate-shaped and may, for example, comprise the same width as the diameter of the cavity, so that the cavity is segmented into several axially extending fluid channels by the segments, which act as partition walls. In this embodiment, the segments are arranged in the cavity in a generally star-shaped pattern.

Furthermore, it may be provided that the base body is traversed by a hollow cylinder running coaxially to the center axis of the base body, which in particular forms a hollow-cylindrical fluid channel. As a result, at least two fluid channels are present in the base body, namely the hollow-cylindrical fluid channel and the fluid channel surrounding it. The surface of the cavity can be increased by the multiple fluid channels and the cooling of the incoming fluid can be accelerated.

One embodiment may be that the fluid channels comprise apertures so that the fluid channels are connected and fluid can flow through them.

In addition, it is advantageous if several segments of a circumferential surface of the hollow cylinder, in particular of the hollow-cylindrical fluid channel, extend radially up to an inner circumferential surface of the base body. In this embodiment, there are also several fluid channels in the cavity, which are formed by the hollow cylindrical fluid channel and the segments that act as partitions. The segments can be arranged in a star shape around the hollow cylindrical fluid channel. With these advantageous embodiments, the surface of the cavity is increased by the multiple fluid channels, so that the contact area with the flowing fluid is increased.

The pressure equalization device can be added to an opening in the housing. When not in use, such an opening can be closed by a covering means. The opening can be specially designed to accommodate a pressure equalization device, by allowing access to an interior space of the housing via the opening. In order to place the pressure equalization device in an opening of the housing, in one embodiment the base body comprises an external thread for reversible connection to an internal thread present in an opening of the housing. The two threads are, of course, aligned with each other so that the pressure equalization device can be easily mounted. In a further embodiment, the base body can comprise at least one fastening element for reversible connection to a connecting means present in an opening of the housing. This can be a snap-in or latching connection that preferably allows the pressure equalization device to be releasably connected to the opening of the housing.

In one embodiment of the pressure equalization device, the base body comprises a circumferential flange near its outlet. After mounting in the opening of the housing, such a flange can be placed against a correspondingly designed counterflange of the housing, simplifying both mounting and dismounting.

To ensure a leak-tight seal between the pressure equalization device and the housing, and in particular to allow controlled pressure equalization, it may be advantageous to provide at least one radially circumferential sealing element on the outside of the base body. The sealing element, for example an O-ring made of an elastomer, can be prestressed in a notch in the base body.

To protect the filter element from the effects of external forces, it may be advantageous to provide a cover for the outlet, which is, for example, detachably connected to the base body. The cover can be attached to the base body by means of a snap-in or latching connection. However, it can also be provided that the cover is hinged to the base body by means of a joint, so that the cover can be pivoted relative to the base body. The use of a detachable cover can facilitate access to the pressure equalization device, in particular the base body, in order to carry out maintenance work. Such maintenance work includes, for example, cleaning the filter element. The addition of the pressure equalization device to the housing can be simplified by an embodiment in which it is provided that the cover comprises a polygonal engagement element designed to engage with a corresponding tool. For example, the engagement element can be designed as a hexagon so that the pressure equalization device can be moved in a torque-transmitting manner using a corresponding tool.

To simplify the installation of the pressure equalization device in a housing, coupling elements can be provided either in the cover or in the base body, which engage in correspondingly arranged coupling element receptacles, designed to receive the coupling elements, either in the base body or in the cover, and ensure that the cover and base body can be connected to each other in a twist-proof manner. The coupling elements can, for example, be designed as cams or raised elements that are attached to the cover, for example, in a circle around a central axis, and project towards the base body. At the same time, pocket-shaped coupling element receptacles can be provided in a circle around a central axis on the base body, in particular near the outlet, which are designed to receive the engagement elements and whose openings point towards the cover. The coupling elements and the coupling element receptacles can be arranged at an angle of 120° or 60° to each other. The advantage of this embodiment is that when the cover and the base body are assembled, they rotate together. Furthermore, latching elements can be provided on the coupling elements that engage behind a surface of the coupling element receptacles so that the cover cannot be removed from the base body by pulling. For example, the cover is inserted with the coupling elements into the coupling element receptacles and turned in one direction so that the cover and base body lock into place. The pressure equalization device can be screwed into a housing, for example, by means of an engagement element attached to the cover, by turning it continuously in the same direction.

It is advantageous if the filter element in the outlet is in the form of a membrane which comprises an oil-repellent layer on its side facing the inlet. The membrane may be made of a plastic and comprise pores for the passage of gas. At least on one side, the membrane is coated with an oil-repellent layer. The oil-repellent layer is advantageously on the side of the membrane facing the inlet. This prevents the oil from leaking out. Furthermore, it can be advantageous if the membrane is designed to be water-repellent on the opposite side to prevent water from penetrating it. The membrane can be attached to the base body using ultrasonic welding, for example.

Another filter element, in particular a gas-permeable filter element, can be present in the inlet or the cap in one embodiment of the pressure equalization device. This filter element may be a membrane or a filter layer. The filter element can be designed to be replaceable so that it can be replaced as needed. A compartment can be provided in the cap, for example, to hold the filter element, with fluid flowing through it. This can achieve a kind of prefiltering and further reduce the penetration of oil into the base body.

In a preferred embodiment, the aperture of the cap is designed to protrude axially through the cap and its diameter is reduced in the axial direction towards the cavity. The advantageous diameter reduction of the aperture in the cap basically acts as a throttle, so that the flow rate of the incoming fluid is reduced. Reducing the flow rate increases the contact time between the surface of the cavity, in particular the fluid channels, and the fluid, allowing the fluid in the fluid channels to cool and condense.

To further reduce the flow rate, a venting element can advantageously be provided in the aperture of the cap. The venting element acts as a flow resistor and is arranged in particular in the flow of the fluid flowing into the base body. The venting element can, for example, be held in place by bar-like elements in the aperture. Due to the cap and its advantageous design, fluid impacts on it and begins to condense.

Fluid, in particular oil condensed in the fluid channels, can flow back into the interior of the housing through the at least one aperture in the cap. It can be advantageous for the base body to comprise at least one aperture near the cap for the flow of fluid. An aperture of this kind in the base body has the advantage that fluid can flow into the fluid channels through it. It also facilitates the drainage of oil condensed in the fluid channels.

One embodiment provides for the cap to be detachably secured to the base body by means of a snap-on, screw or latching connection. This allows access to the pressure equalization device, in particular to the base body, for maintenance purposes. Such maintenance work includes, for example, cleaning the fluid channels or replacing or cleaning the filter element.

The invention will be explained in more detail below, with reference to an example of the invention shown in the drawing. It shows
- Figure 1: an exploded view of a pressure equalization device,
- Figure 2: a perspective view of a pressure equalization device,
- Figure 3: a perspective view of a pressure equalization device from an oblique angle from below,
- Figure 4: a plan view of a pressure equalization device,
- Figure 5: a sectional view along A-A of the pressure equalization device shown in Figure 4,
- Figure 6: a sectional view along B-B of the pressure equalization device of Figure 4, and
- Figure 7: a sub-view of a pressure equalization device.

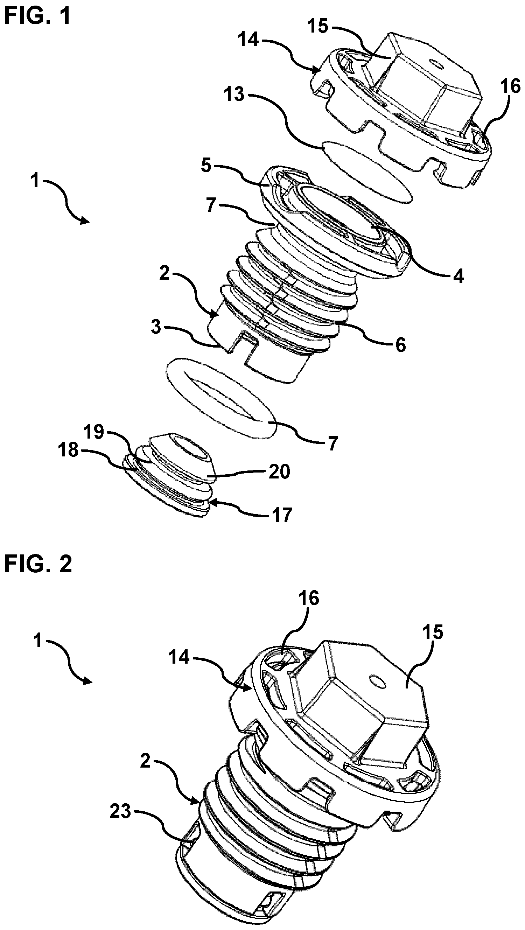

The following text refers to Figures 1 to 7. The pressure equalization device 1 comprises a base body 2, which is designed in a tubular shape in the example shown. The base body 2 can be made of a plastic. The base body 2 comprises a first and a second axial end, which are located opposite each other. An inlet 3 is provided at the first axial end and an outlet 4 is provided at the second axial end. When using pressure equalization device 1, that is, when pressure equalization device 1 is inserted into an opening of a housing not shown, the inlet 3 extends into an interior space of the housing. The opening of the housing is designed accordingly for this purpose and can be closed by a covering means when not in use. In contrast, the outlet 4 extends into an environment of the housing.

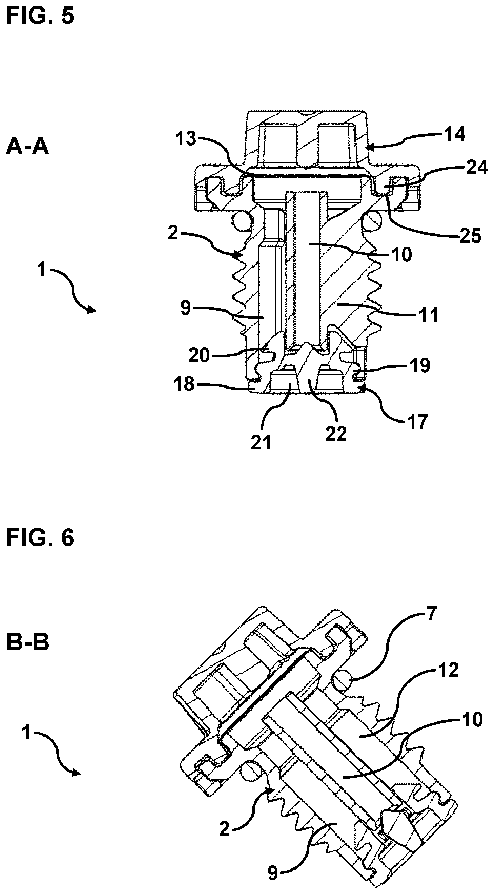

A circumferential flange 5 is provided near outlet 4, which extends beyond the circumferential surface of the base body 2. The flange 5 is embodied in the form of a collar and is manufactured in one piece with the base body 2. In the design shown, an external thread 6 is provided in the circumferential surface of the base body 2, adjacent to the flange 5 and extending in the direction of the inlet 3. Between the thread 6 and the flange 5, a sealing element 7 is arranged in a circumferential notch 8, as can be clearly seen in Figures 5 and 6. The sealing element 7 can be designed as an O-ring and can be radially prestressed in the notch 8. Depending on the requirements, further sealing elements 7 can be provided on the circumferential surface of the base body 2. By means of the thread 6, the pressure equalization device 1 can be screwed into the opening of the housing comprising an internal thread. Sealing is achieved by means of at least one sealing element 7, which, for example, is placed in a sealing manner against a correspondingly provided contact surface of the housing. However, the pressure equalization device 1 can also be attached to the housing in a different way, for example with a snap-on or latching or press-fit connection. For this purpose, in one embodiment of the invention, corresponding snap-on or latching elements can be provided on the base body 2.

As can be clearly seen in the sectional views in Figures 5 and 6, the base body 2 delimits a cavity 9 that extends from the inlet 3 to the outlet 4. The cavity 9 basically comprises the inner contour of the base body 2 and is essentially tubular in the embodiment shown. A hollow cylindrical fluid channel 10 is arranged in the center of the cavity 9 and extends axially along the longitudinal axis of the base body 2. The hollow cylindrical fluid channel 10 is basically coaxial with the center axis of the cavity 9 and the base body 2. The open ends of the hollow cylindrical fluid channel 10 lead to the inlet 3 and outlet 4 so that a flow through the hollow cylindrical fluid channel 10 is possible in both directions, i.e. from the inlet opening 3 to the outlet opening 4 and vice versa. The hollow cylindrical fluid channel 10 can be held in position by means of bar-like elements, not shown in the figure, which extend from its circumferential surface to the inner circumferential surface of the cavity 9. In this embodiment, the cavity 9 also forms a fluid channel for fluid flow in addition to the hollow cylindrical fluid channel 10.

The figures show an embodiment of the invention in which segments 11 extend radially from the circumferential surface of the hollow-cylindrical fluid channel 10 to the inner circumferential surface of the cavity 9, which segments 11 expand axially to the longitudinal axis of the base body 2. The segments 11 can be designed to be trapezoidal or rectangular, wherein the longitudinal sides of the segments 11 are fixed to the circumferential surface of the hollow cylindrical fluid channel 10 and the inner circumferential surface of the cavity 9. The free ends of the segments 11, that is to say, in particular their narrow sides, each point in the direction of the inlet 3 and the outlet 4. The segments 11 divide the cavity 9 into a plurality of fluid channels 12 running axially in the cavity 9, so that segmented fluid channels 12 are formed. The hollow cylindrical fluid channel 10 and the segmented fluid channels 12 allow a flow through the cavity 9 from the inlet 3 to the outlet 4 and vice versa. The segmented fluid channels 12 and the hollow cylindrical fluid channel 10 are referred to as fluid channels for the purposes of the invention. The fluid channels 10, 12 can be manufactured as a single part that is inserted into the cavity 9. For this purpose, the cavity 9 can comprise corresponding radial and axial bearing means or fastening means to ensure that the fluid channels 10, 12 are securely seated in the cavity 9. However, it may also be advantageous if the base body 2 together with the fluid channels 10, 12 is provided in a plastic manufacturing process, e.g. in an injection molding process.

In particular, a filter element 13 is provided at the free end of the base body 2, which forms the outlet 4, which in the design shown is in the form of a membrane. The membrane may be a polytetrafluoroethylene membrane (ePTFE), which is gas permeable but oil repellent. In particular, the side of the filter element 13 facing the inlet 3 is oil repellent. The filter element 13 can be clamped in the base body 2, for example. The filter element 13 is advantageously attached in the outlet 4 by means of ultrasonic welding. The embodiment of the filter element 13, in particular the use of different membranes with different physical and chemical properties, can be adapted to the use of the pressure equalization device 1. The filter element 13 is preferably positioned on the outlet 4 in such a way that it can be removed after contamination or damage and the base body 2 can be reused, for example by inserting a new filter element 13.

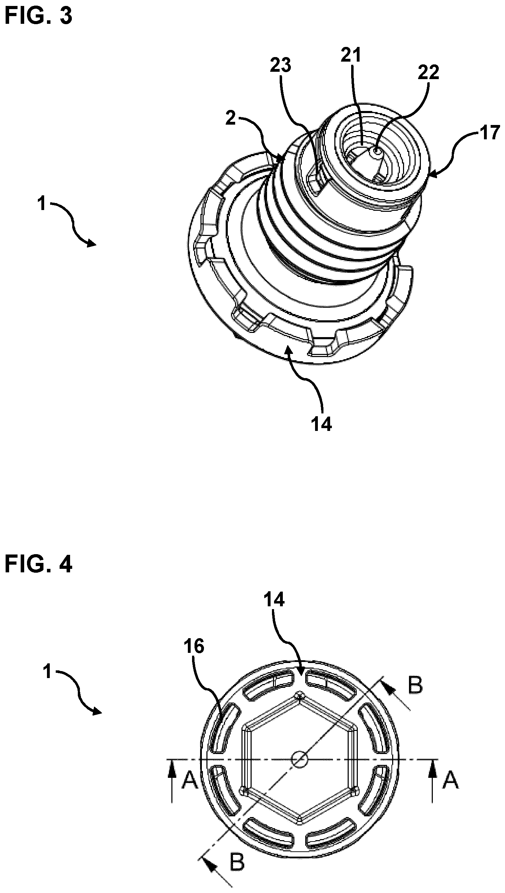

The outlet 4 is covered by a cover 14, which may comprise a round base shape, from which a polygonal engagement element 15 protrudes axially. The engagement element 15 can be engaged with a corresponding tool, with the aid of which the pressure equalization device 1 is screwed into the opening in the housing, for example. The cover 14 itself can be connected to the base body 2 in a non-rotatable manner by means of known snap-in or latching connections. The cover 14 is provided with at least one aperture 16 which connects the cavity 9 to the environment in fluidic terms, so that a fluid coming from the inlet 3 can flow through the fluid channels 10, 12, through the filter element 13 in the outlet 4 and the at least one aperture 16 in the cover 14. For the purposes of the invention, an aperture can be described as an opening in a wall and allows, for example, the passage of a fluid. In the illustrated example, there are several apertures 16 in the cover that pass axially through the basic shape of the cover 14, as can be clearly seen in Figure 4. The cover 14 can be made of plastic. It can also be envisaged that the cover 14 and base body 2 are manufactured in one piece and the cover 14 is mounted on the base body such that it can move, for example via a hinge. In a further embodiment, the cover 14 is fastened to the base body 2 such that it can be completely detached. This embodiment has the advantage that the filter element 13 is accessible.

A cap 17 is provided at the inlet 3, which is located axially opposite the outlet 4. As can be clearly seen in Figure 1, the cap 17 comprises a round base part 18, which is adapted, at least partially, to the shape of the base body 2, in particular the cavity 9. The base part 18 is at least partially inserted into the cavity 9 of the base body 2. A snap-in or latching connection can be used to reversibly connect the cap 17 to the base body 2. In the embodiment shown, the base part 18 comprises a radially resilient shoulder 19 that is designed to engage in a notch in the cavity 9 and latch there, see e.g. Figures 5 and 6. The snap-fit can be released again by radially compressing the base part 18, for example using a tool, and the cap 17 can be released from the base body 2. Above the circumferential shoulder 19, the base part 18 comprises a truncated cone-shaped element 20, which is offset from the circumferential shoulder 19 by a circumferential notch. The truncated cone-shaped element 20 has a smaller outer diameter than the circumferential shoulder 19. In the center of the base part 18, basically coaxial to the center axis of the cavity 9 and the base body 2 is an aperture 21 in the base part 18. As can be clearly seen in Figures 5 and 6, the aperture 21 of the base part 18 is arranged close to the hollow cylindrical fluid channel 10 of the base body 2.

The aperture 21 in the base part 18 is designed in such a way that its diameter is reduced axially towards the cavity 9 of the base body 2. That is to say, in a first stepped region, the aperture 21 comprises a larger diameter than in the subsequent second stepped region, which is at least partially formed by the truncated cone-shaped element 20. This step-shaped axial diameter reduction of the aperture 21 in the cap 17 forms, on the one hand, an impact surface for incoming fluid and, on the other hand, the aperture 21 acts as a throttle to reduce the flow velocity of the incoming fluid.

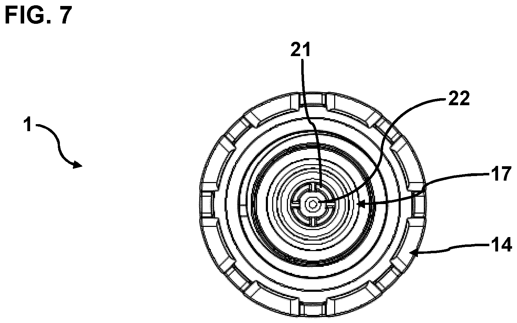

A venting element 22 in the shape of an arrow is provided in the center of the aperture 21 in the base part 18, see for example Figures 3 and 7. The venting element 22 can be attached to the base part 18 by bar-like elements. The venting element 22 can act as a throttle to regulate volume flows. The venting element 22 represents a narrowing of the aperture 21 in the base part 18 and can thus be used as a localized flow resistance.

The following is an example of how the pressure equalization device 1 works, based on an engine housing. Pressure fluctuations can occur, especially when transporting the engine housing by air, for example, and these must be equalized to prevent damage to the engine housing. The pressure equalization device 1 can be screwed into an opening provided for this purpose in the motor housing, so that the inlet 3 is connected to an interior of the motor housing and the outlet 4 is connected to an environment. If there is overpressure in the interior compared to the environmental pressure, this can be equalized via the pressure equalization device 1 by fluid flowing from the interior through the cap 17 and the fluid channels 10, 12 in the cavity 9, through the filter element 13 in the outlet 4 and the at least one aperture 16 in the cover 14. If the fluid is present as an aerosol, which, in addition to a gaseous component, also includes a liquid component, in particular oil, the filter element 13 can become covered with oil and thus clogged. Due to the favorable embodiment of the pressure equalization device 1, the flow rate of the fluid is reduced by the use of the cap 17 and in particular the fluid channels 10, 12. The cap 17 can already reduce the penetration of the oil into the fluid channels 10, 12 by causing the oil to deflect at the stepped design of the aperture 21 and liquefy. In addition, the stepped, in particular diameter-reducing design of the aperture 21 in the cap 17 acts as a throttle element to reduce the flow velocity of the flowing fluid. The same function can be attributed to the venting element 22, which also reduces the flow velocity of the incoming fluid. Thus, the cap 17 already functions as an oil separator, so that oil can condense here and flow back into the interior.

Fluid flowing into cavity 9 thus already comprises a reduced flow velocity. The temperature of the fluid continues to decrease in the fluid channels 10, 12 and the liquid, especially the oil, condenses in the fluid channels 10, 12. Due to the multiple, especially segmented fluid channels 12, the surface of the cavity 9 is increased, which promotes the cooling and condensation of the oil.

The liquefied oil can flow back into the interior via the fluid channels 10, 12 and the at least one aperture 21 in the cap 17. In addition, it may be provided that the base body 2 comprises openings or apertures 23 in its wall in the area of the truncated cone-shaped element 20. This not only allows fluid to flow into the cavity 9, or more precisely into the fluid channels 10, in order to be cooled there, but also allows condensed oil to flow out of the fluid channels 10 through the apertures 23 in the base body 2. The pressure equalization device 1 not only enables efficient pressure equalization, but also the use of a filter element 13, for example, to retain a liquid, in particular oil, wherein clogging of the filter element 13 is prevented by the preferred embodiment of the pressure equalization device 1, in particular the fluid channels 10, 12 and the cap 17.

With an embodiment of the invention, which is exemplarily shown in figures 5 and 6, the assembly of the pressure equalization device 1 in a housing can be simplified. For this purpose cams 24 are provided on the cover 14 as coupling elements, which are arranged in a circle around the center axis of the cover 14 and project towards the base body 2. At the same time, pocket-shaped coupling element receptacles 25 can be provided in a circle around a central axis on the base body 2, in particular near the outlet opening 4, which are designed to receive the cams 24 and whose openings extend in the direction of the cover 14. The advantage of this embodiment is that when the cover 14 and the base body 2 are assembled, they rotate together in a twist-proof manner.

## Claims

1. Pressure equalization device (1) for attachment to an opening of a housing, comprising a base body (2) that includes an inlet (3) and an outlet (4), wherein the inlet (3) is designed to be fluidically connected to an interior of the housing and the outlet (4) is designed to be fluidically connected to an environment of the housing, wherein said inlet and outlet (3, 4) are fluidically connected via a plurality of fluid channels (10, 12) extending in the base body (2), and with a gas-permeable and oil-repellent filter element (13) provided in the outlet (4), wherein a cap (17) is attached to the inlet (3), which cap (17) comprises at least one aperture (21) for the flow of a fluid.

2. Pressure equalization device (1) according to claim 1, **characterized in that** a fluid channel (10) is formed by a hollow cylinder running coaxially to the center axis of the base body (2).

3. Pressure equalization device (1) according to one of the preceding claims, **characterized in that** the base body (2) encloses a cavity (9) which is subdivided by a plurality of radially running segments (11) extending axially to the longitudinal axis of the base body (2).

4. Pressure equalizing device (1) according to claim 3, **characterized in that** the segments (11) extend radially from a circumferential surface of the hollow cylinder to an inner circumferential surface of the base body (2).

5. Pressure equalization device (1) according to one of the preceding claims, **characterized in that** the base body (2) comprises a circumferential flange (5) near its outlet (4).

6. Pressure equalization device (1) according to one of the preceding claims, **characterized in that** at least one radially encircling sealing element (7) is provided on the outside of the base body (2).

7. Pressure equalization device (1) according to one of the preceding claims, **characterized in that** the base body (2) comprises an external thread (6) for reversible connection to an internal thread present in the opening of the housing.

8. Pressure equalization device (1) according to one of the preceding claims, **characterized in that** a cover (14) comprising at least one aperture (16) is attached to the base body (2) for the purpose of detachably covering the outlet (4).

9. Pressure equalization device (1) according to claim 8, **characterized in that** the cover (14) comprises a polygonal engagement element (15) designed for engagement with a corresponding tool.

10. Pressure equalization device (1) according to one of the preceding claims, **characterized in that** the filter element (13) in the outlet (4) is designed as a membrane, which comprises an oil-repellent layer on its side facing the inlet (3).

11. Pressure equalization device (1) according to one of the preceding claims, **characterized in that** a gas-permeable filter element is present in the inlet (3) or the cap (17).

12. Pressure equalization device (1) according to one of the preceding claims, **characterized in that** the aperture (21) of the cap (17) protrudes axially through the cap (17) and its diameter decreases in the axial direction towards the cavity (9).

13. Pressure equalization device (1) according to one of the preceding claims, **characterized in that** a venting element (22) is present in the aperture (21) of the cap (17).

14. Pressure equalization device (1) according to one of the preceding claims, **characterized in that** the base body (2) comprises at least one aperture (23) near the cap (17) for the flow of fluid.

15. Pressure equalization device (1) according to one of the preceding claims, **characterized in that** the cap (17) is detachably held on the base body (2) by means of a snap-on, screw or latching connection.
